(19) Europäisches Patentamt / European Patent Office / Office européen des brevets

(11) **EP 4 760 308 A1**

(12) **EUROPEAN PATENT APPLICATION**
published in accordance with Art. 153(4) EPC

(43) Date of publication:
**17.06.2026 Bulletin 2026/25**

(21) Application number: **24877387.1**

(22) Date of filing: **14.08.2024**

(51) International Patent Classification (IPC):
*G01R 31/392* (2019.01)   *G01R 31/382* (2019.01)
*G01R 31/3835* (2019.01)   *G01R 31/396* (2019.01)
*G01R 31/36* (2020.01)   *G01R 31/367* (2019.01)
*G01R 19/12* (2006.01)   *G06F 17/18* (2006.01)
*B60L 58/16* (2019.01)   *H01M 10/0525* (2010.01)

(52) Cooperative Patent Classification (CPC):
**B60L 58/16; G01R 19/12; G01R 31/36;
G01R 31/367; G01R 31/382; G01R 31/3835;
G01R 31/392; G01R 31/396; G06F 17/18;
H01M 10/0525;** Y02E 60/10

(86) International application number:
**PCT/KR2024/012150**

(87) International publication number:
**WO 2025/079848 (17.04.2025 Gazette 2025/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **12.10.2023   KR 20230136073**

(71) Applicant: **LG Energy Solution, Ltd.
Seoul 07335 (KR)**

(72) Inventors:
• **YOON, Du Seong
  Daejeon 34122 (KR)**

• **LEE, Bom Jin
  Daejeon 34122 (KR)**
• **LIM, Bo Mi
  Daejeon 34122 (KR)**
• **JEON, Chul Min
  Daejeon 34122 (KR)**
• **YANG, Won Seok
  Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY MANAGEMENT APPARATUS AND OPERATION METHOD THEREFOR**

(57)   A battery management device according to an embodiment disclosed herein may include an acquisition unit configured to acquire voltages of a plurality of battery cells, and a controller configured to calculate a voltage profile for a voltage of each of the plurality of battery cells, linearly fit the voltage profile in a preset time section and calculate a slope of the voltage profile, and diagnose a state of each of the plurality of battery cells based on the slope of the voltage profile of each of the plurality of battery cells.

```
CALCULATE VOLTAGE PROFILE FOR VOLTAGE OF
EACH OF PLURALITY OF BATTERY CELLS          —S101
              |
              v
LINEARLY FIT VOLTAGE PROFILE IN PRESET
TIME SECTION AND CALCULATE SLOPE            —S102
OF VOLTAGE PROFILE
              |
              v
DIAGNOSE STATE OF EACH OF PLURALITY OF
BATTERY CELLS BASED ON SLOPE OF VOLTAGE     —S103
PROFILE OF EACH OF PLURALITY OF BATTERY CELLS
```

FIG.5

EP 4 760 308 A1

## Description

## Technical Field

CROSS-REFERENCE TO RELATED APPLICATION

This application claims priority to and the benefit of Korean Patent Application No. 10-2023-0136073 filed in the Korean Intellectual Property Office on October 12, 2023, the entire contents of which are incorporated herein by reference.

TECHNICAL FIELD

Embodiments disclosed herein relate to a battery management device and a method of operating the same.

## Background Art

Recently, research and development on secondary batteries has been actively conducted. Here, the secondary battery is a battery capable of charging and discharging and may be construed as including all recent lithium ion batteries such as conventional Ni/Cd batteries and Ni/MH batteries. Recently, the lithium-ion batteries are attracting attention as a next-generation energy storage medium as a range of use expands to a power source for an electric vehicle.

Electric vehicles receive electricity from the outside, charge battery cells, and then discharge the battery cells to drive a motor and obtain power. The battery cells may have problems in production and usage stages of the battery cells. For example, structural defects (e.g., overhang) occur in the battery cells in the production stage of the battery cell. In addition, the physical and chemical characteristics of the battery cell may be changed through various charging and discharging in the use stage of the battery cell. Therefore, there is a need for a technology of diagnosing and managing battery cell problems caused by defective production or deterioration of the battery cell.

A charging and discharging test may be performed on battery cells for various purposes, such as the performance diagnosis and state analysis of a battery. Based on a current and voltage acquired through the charging and discharging test, a profile of an open circuit voltage (OCV) of the battery cell may be calculated. In addition, defects in the battery cell may be detected by analyzing the profile of the OCV.

## Disclosure

## Technical Problem

Embodiments disclosed herein are directed to providing a battery management device and a method of operating the same, which may diagnose the defect or deterioration of each of a plurality of battery cells included in a battery cell pack.

Embodiments disclosed herein are directed to providing a battery management device and a method of operating the same, which may diagnose a cell in which Li-plating has occurred among a plurality of battery cells included in a battery cell pack.

The technical objects of the embodiments disclosed herein are not limited to the above-described technical objects, and other objects that are not described will be able to be clearly understood by those skilled in the art from the following descriptions.

## Technical Solution

A battery management device according to an embodiment disclosed herein may include an acquisition unit configured to acquire voltages of a plurality of battery cells, and a controller configured to calculate a voltage profile for a voltage of each of the plurality of battery cells, linearly fit the voltage profile in a preset time section and calculate a slope of the voltage profile, and diagnose a state of each of the plurality of battery cells based on the slope of the voltage profile of each of the plurality of battery cells.

According to an embodiment, the preset time section may include an idle section after discharging of each of the plurality of battery cells is completed.

According to an embodiment, the controller may linearly fit the voltage profile of each of the plurality of battery cells using a linear regression method.

According to an embodiment, the controller may be configured to calculate a linear profile that is a profile obtained by linearly fitting the voltage profile, and calculate an average change rate that is a ratio of a voltage change amount to a time change amount in the linear profile and calculate the slope.

According to an embodiment, the controller may compare the slope of each of the plurality of battery cells with a threshold value and diagnose a battery cell having the slope smaller than the threshold value as being in an abnormal state.

According to an embodiment, the controller may be configured to calculate distribution of the slopes related to the plurality of battery cells, and determine the threshold value based on the distribution of the slopes.

According to an embodiment, the controller may determine that a reference value based on an average of the distribution of the slopes and a standard deviation of the distribution is the threshold value.

According to an embodiment, the controller may diagnoses the battery cell having the slope smaller than the threshold value as a cell in which Li-plating has occurred.

According to an embodiment, the voltage of each of the plurality of battery cells may be an open circuit voltage (OCV).

According to an embodiment, a battery management method according to one embodiment disclosed herein may include calculating a voltage profile for a voltage of each of a plurality of battery cells, linearly fitting the voltage profile in a preset time section and calculating a slope of the voltage profile, and diagnosing a state of each of the plurality of battery cells based on the slope of the voltage profile of each of the plurality of battery cells.

According to an embodiment, the preset time section may include an idle section after discharging of each of the plurality of battery cells is completed.

According to an embodiment, the battery management method may include linearly fitting the voltage profile of each of the plurality of battery cells using a linear regression method.

According to an embodiment, the calculating of the slope of the voltage profile may include calculating a linear profile that is a profile obtained by linearly fitting the voltage profile, and calculating an average change rate that is a ratio of a voltage change amount to a time change amount in the linear profile and calculating the slope.

According to an embodiment, the diagnosing of the state of each of the plurality of battery cells may include comparing the slope of each of the plurality of battery cells with a threshold value and diagnosing a battery cell having the slope smaller than the threshold value as being in an abnormal state.

According to an embodiment, the battery management method may further include calculating distribution of the slopes related to the plurality of battery cells, and determining the threshold value based on the distribution of the slopes.

According to an embodiment, the determining of the threshold value based on the distribution of the slopes may include determining that a reference value based on an average of the distribution of the slopes and a standard deviation of the distribution is the threshold value.

According to an embodiment, the diagnosing of the battery cell having the slope smaller than the threshold value as being in the abnormal state may be diagnosing the battery cell having the slope smaller than the threshold value as a cell in which Li-plating has occurred.

According to an embodiment, the voltage of each of the plurality of battery cells may be an open circuit voltage (OCV).

**Advantageous Effects**

According to the battery management device and the method of operating the same according to the embodiments disclosed herein, it is possible to diagnose the defect or deterioration of each of the plurality of battery cells included in the battery cell pack.

According to the battery management device and the method of operating the same according to the embodiments disclosed herein, it is possible to diagnose the cell in which Li-plating has occurred among the plurality of battery cells included in the battery cell pack in the non-destructive manner.

In addition, various effects that may be directly or indirectly identified through the present document can be provided.

**Description of Drawings**

FIG. 1 is a view showing a battery cell pack according to one embodiment disclosed herein.

FIG. 2 is a block diagram showing a battery management device according to one embodiment disclosed herein.

FIG. 3 is a view showing a voltage profile of a battery cell according to one embodiment disclosed herein.

FIG. 4 is an enlarged view of the voltage profile of the battery cell according to one embodiment disclosed herein.

FIG. 5 is a flowchart of an operation of the battery management device according to one embodiment disclosed herein.

FIG. 6 is a flowchart of the operation of the battery management device according to one embodiment disclosed herein.

FIG. 7 is a block diagram showing a hardware configuration of a computing system for performing a method of operating the battery management device according to one embodiment disclosed herein.

**Mode for Invention**

Hereinafter, various embodiments of the present disclosure will be described with reference to the accompanying drawings. However, it should be understood that this is not intended to limit the present disclosure to specific embodiments and includes various modifications, equivalents, and/or alternatives of the embodiments of the present disclosure.

It should be understood that various embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. The terms such as "first," "second," "primary," "secondary," "A," "B," "(a)," or "(b)" may simply be used to distinguish the corresponding component from another and do not limit the corresponding components in another aspect (e.g., importance or order).

In the present document, when a certain (e.g., a first) component is described as being "connected," "coupled," or "joined or "coupled" or "connected" to another (e.g., a second) component with or without the terms "functionally" or "communicatively," this means that the certain component may be connected to another component directly (e.g., by wire), wirelessly, or through a third component.

According to one embodiment, a method according to various embodiments disclosed herein may be provided by being included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through an application store or directly online between two user devices. In the case of the online distribution, at least some of the computer program products may be at least temporarily stored or temporarily generated in a device-readable storage medium such as a memory of a server of a manufacturer, a server of an application store, or a relay server.

According to various embodiments, each component (e.g., a module or a program) of the above-described components may include a single object or a plurality of objects, and some of the plurality of objects may be separately disposed in another component. According to various embodiments, one or more of the above-described corresponding components or their operations may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to various embodiments, operations performed by modules, programs, or other components may be executed sequentially, in parallel, repeatedly, or heuristically, or one or more of the operations may be executed in a different order or omitted, or one or more other operations may be added.

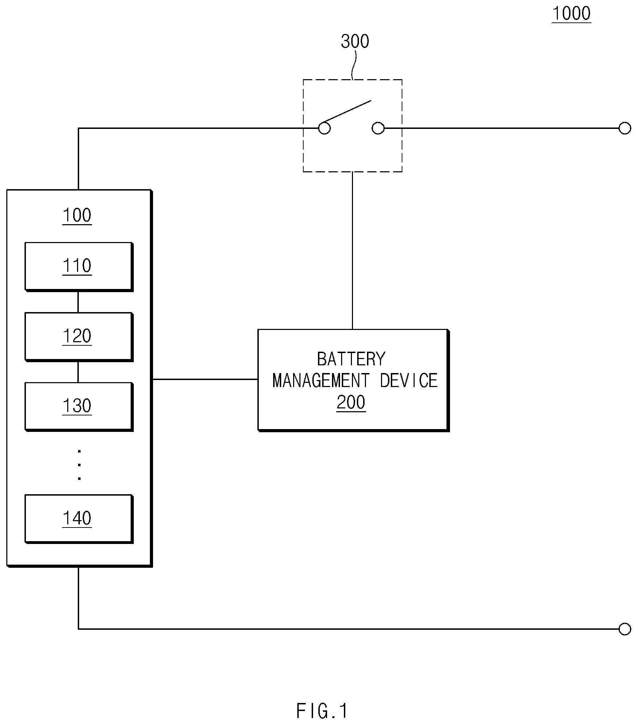

FIG. 1 is a view showing a battery cell pack according to one embodiment disclosed herein.

Referring to FIG. 1, a battery cell pack 1000 according to one embodiment disclosed herein may include a battery cell module 100, a battery management device 200, and a relay 300. According to various embodiments, the battery cell module 100 may be a battery cell, and in this case, the battery cell pack 1000 may have a cell-to-pack structure.

Although FIG. 1 shows a case of one battery cell module 100, according to an embodiment, a plurality of battery cell module 100 may be configured, and the battery cell pack 1000 may have a stacked structure of a plurality of battery cell modules 100.

The battery cell module 100 may include a plurality of battery cells 110, 120, 130, and 140. FIG. 1 shows four battery cells, but the present document is not limited thereto, and the battery cell module 100 may include n (n is a natural number more than or equal to 2) battery cells.

The battery cell module 100 may supply power to a target device (not shown). To this end, the battery cell module 100 may be electrically connected to the target device. Here, the target device may include an electrical, electronic, or mechanical device operated by receiving power from the battery cell pack 1000 including the plurality of battery cells 110, 120, 130, and 140. For example, the target device may be an electric vehicle (EV) or an energy storage system (ESS), but is not limited thereto.

The plurality of battery cells 110, 120, 130, and 140 are basic units of battery cells that may be used by charging and discharging electric energy, and may be Li-ion batteries, Li-ion polymer batteries, Ni-Cd batteries, Ni-MH batteries, etc., but are not limited thereto. Meanwhile, FIG. 1 shows a single battery cell module 100, but according to an embodiment, a plurality of battery cell modules 100 may be configured.

The battery management device 200 may manage and/or control a state and/or operation of the battery cell module 100. For example, the battery management device 200 may manage and/or control states and/or operations of the plurality of battery cells 110, 120, 130, and 140 included in the battery cell module 100. The battery management device 200 may manage charging and/or discharging of the battery cell module 100.

The battery management device 200 may control an operation of the relay 300. For example, the relay 300 may be shorted by the battery management device 200 to supply power to the target device. In addition, the relay 300 may be shorted by the battery management device 200 when a charging device is connected to the battery cell pack 1000.

In addition, the battery management device 200 may monitor a voltage, current, temperature, etc. of the battery cell module 100 and/or each of the plurality of battery cells 110, 120, 130, and 140 included in the battery cell module 100. In addition, for monitoring by the battery management device 200, sensors or various measurement modules that are not shown may be additionally installed in the battery cell module 100, charging and discharging paths, or any location of the battery cell module 100, etc. The battery management device 200 may calculate a parameter representing a state of the battery cell module 100, such as a state of charge (SOC) or state of health (SOH), based on measured values of the monitored voltage, current, temperature, etc.

According to various embodiments, a defect (e.g., overhang) may occur in the battery cell in production processes of the battery cell module 100 and the plurality of battery cells 110, 120, 130, and 140. A normal battery cell has a larger area of a negative electrode than an area of a positive electrode, but a defective battery cell in which overhang has occurred may have a smaller area of the negative electrode than the area of the positive electrode. Therefore, the defective battery cell in which overhang has occurred may have a shape in which a positive electrode portion facing a portion of the positive electrode is not present and the positive electrode protrudes. Therefore, Li-plating may occur in a usage process of the defective battery cell.

In addition, as the battery cell module 100 and the plurality of battery cells 110, 120, 130, and 140 increase in a usage period or the number of usages, capacity may decrease, internal resistance may increase, or Li-plating may occur. Therefore, the battery management device 200 may diagnose an abnormal phenomenon inside the battery cell module 100 and the plurality of battery cells 110, 120, 130, and 140 based on data of various factors that change according to the defect or deterioration of the battery cell.

According to an embodiment, the battery management device 200 may diagnose a battery cell in which Li-plating has occurred by analyzing voltage data of each of the plurality of battery cells 110, 120, 130, and 140. Here, The Li-plating may be a phenomenon in which metallic lithium is precipitated from the negative electrode of the battery cell. When the Li-plating occurs in the battery cell, the battery cell may catch fire in the usage process of the battery cell.

Therefore, the battery management device 200 may diagnose a battery cell in which Li-plating has occurred without disassembling the battery cell by analyzing the voltage data of each of the plurality of battery cells 110, 120, 130, and 140. Therefore, the battery management device 200 may quickly and accurately diagnose a defect or abnormal state of the battery cell in a nondestructive manner and prevent catching fire.

The battery management device 200 may be various electronic devices for managing, diagnosing, or testing a battery. For example, the battery management device 200 may be included in a battery management system (BMS) inside or outside a vehicle and implemented as a separate external device distinct from the BMS inside the vehicle. According to an embodiment, the battery management device 200 may be included in a device for a charging and discharging test, such as a server, a cloud server, or a charging and discharging cycler and included in various devices for diagnosing or testing a battery.

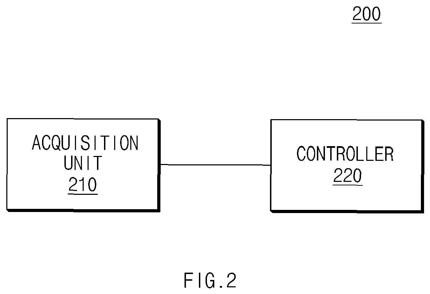

FIG. 2 is a block diagram showing a battery management device according to one embodiment disclosed herein.

Referring to FIG. 2, the battery management device 200 may include an acquisition unit 210 and a controller 220. However, the present document is not limited thereto, and some components may be omitted from the battery management device 200, or other general-purpose components may be further included in the battery management device 200.

The acquisition unit 210 may acquire state information of each of the plurality of battery cells 110, 120, 130, and 140. For example, the acquisition unit 210 may acquire a voltage, current, temperature, etc. of each of the plurality of battery cells 110, 120, 130, and 140.

According to an embodiment, the acquisition unit 210 may acquire a voltage of each of the plurality of battery cells 110, 120, 130, and 140. The acquisition unit 210 may acquire the voltage of each of the plurality of battery cells 110, 120, 130, and 140 per unit time. According to an embodiment, the acquisition unit 210 may continuously acquire data related to voltage rise and voltage drop in charging sections, idle-after-charging sections, discharging sections, and/or idle-after-discharging sections of the plurality of battery cells 110, 120, 130, and 140. According to an embodiment, the acquisition unit 210 may include a voltage monitoring circuit or a sensor.

The controller 220 may control operations of the battery management device 200. According to an embodiment, the controller 220 may diagnose a state of each of the plurality of battery cells 110, 120, 130, and 140 based on the state information of each of the plurality of battery cells 110, 120, 130, and 140 acquired from the acquisition unit 210. For example, the controller 220 may calculate a voltage profile based on the state information (e.g., a voltage) of each of the plurality of battery cells 110, 120, 130, and 140 and analyze the calculated voltage profile to diagnose the state of each of the plurality of battery cells 110, 120, 130, and 140.

According to an embodiment, the controller 220 may calculate the voltage profile of each of the plurality of battery cells 110, 120, 130, and 140 for an idle-after-discharging cycle of each of the plurality of battery cells 110, 120, 130, and 140. Therefore, the controller 220 may acquire more voltage profiles for diagnosing the states of the plurality of battery cells 110, 120, 130, and 140 and increase the accuracy of the diagnosis.

According to an embodiment, the battery cell (e.g., battery cell 110) may be a defective (e.g., overhang) cell due to a problem in a production stage. Alternatively, although there was no problem in the production stage, the battery cell 110 may deteriorate as the battery cell 110 is repeatedly charged and discharged. In the case of such defects or deterioration, Li-plating in which metallic lithium is precipitated may occur at the negative electrode of the battery cell 110. In addition, the defects and deterioration of the battery cell 110 may reduce the performance of the battery cell 110 compared to an initial state of production of a normal battery cell. In addition, continued use of the battery cell 110 in a defective or deteriorated state may lead to catching fire of the battery cell 110. Therefore, the battery management device 200 including the controller 220 may manage the plurality of battery cells 110, 120, 130, and 140 by checking and diagnosing the state of each of the plurality of battery cells 110, 120, 130, and 140.

According to various embodiments, since no current flows to the positive and negative electrodes of the battery cell in the idle-after-discharge section of the battery cell, lithium ions may move to an equilibrium state at the positive and negative electrodes. Due to the movement of the lithium ions, the voltage (e.g., the OCV) of the battery cell may change in the idle-after-discharging section. However, when an abnormality such as Li-plating occurs in the battery cell, the time the lithium ions reach the equilibrium state in the idle-after-discharging section may be longer. Therefore, in the battery cell in the abnormal state, a change in OCV in the idle-after-discharging section may occur more slowly than in the battery cell in the normal state.

According to an embodiment, the controller 220 may diagnose the battery cell in the abnormal state based on the voltage in an idle section after the discharging of the plurality of battery cells 110, 120, 130, and 140 is completed. For example, the controller 220 may diagnose a battery cell in which Li-plating has occurred by analyzing a slope of an open circuit voltage profile. Therefore, the controller 220 may manage the plurality of battery cells 110, 120, 130, and 140 based on voltage information acquired without disassembling or destroying the plurality of battery cells 110, 120, 130, 140 and prevent catching fire.

The controller 220 may control the operation of each of the plurality of battery cells 110, 120, 130, and 140 to manage each of the plurality of battery cells 110, 120, 130, and 140. According to an embodiment, the controller 220 may control the charging and/or discharging of each of the plurality of battery cells 110, 120, 130, and 140.

The controller 220 may have a structure for executing commands that implement the operations of the battery management device 200. The controller 220 may be implemented as an array of a plurality of logic gates or general-purpose microprocessor for processing various operations and configured as a single processor or a plurality of processors. For example, the controller 220 may be implemented in the form of at least one of a microprocessor, a CPU, a GPU, and an AP.

The controller 220 may be configured separately or integrally with a memory and/or storage configured to temporarily store data or commands and may process various calculations by executing the commands stored in the memory and/or the storage. The memory and/or the storage may store various pieces of data, commands, mobile applications, computer programs, etc. For example, the memory and/or the storage may be implemented as a non-volatile device such as a ROM, a PROM, an EPROM, an EEPROM, a flash memory, a PRAM, an MRAM, a RRAM, or an FRAM or a volatile device such as a DRAM, an SRAM, an SDRAM, a PRAM, an RRAM, or an FeRAM and implemented in the form of an HDD, an SSD, an SD, a Micro-SD, or a combination thereof.

The controller 220 may provide a user with information about a deterioration state or voltage profile of each of the plurality of battery cells 110, 120, 130, and 140. For example, the controller 220 may provide a user terminal with information about the deterioration state or voltage profile through a communication unit (not shown) and also provide information about the deterioration state or voltage profile through a display provided in a vehicle, a charger, etc.

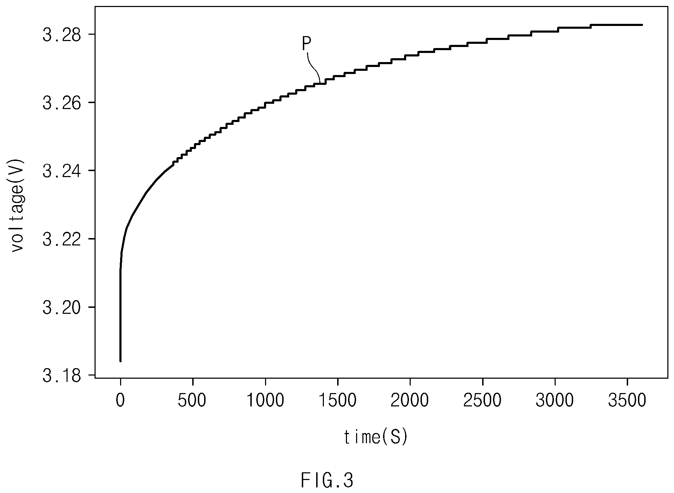

FIG. 3 is a view showing a voltage profile of a battery cell according to one embodiment disclosed herein.

Referring to FIG. 3, the controller 220 may acquire time series data of the voltage of each of the plurality of battery cells 110, 120, 130, and 140 based on the voltage data of the plurality of battery cells 110, 120, 130, and 140 acquired from the acquisition unit 210 per unit time. According to an embodiment, the voltage data of the plurality of battery cells 110, 120, 130, and 140 may be acquired in a preset time section. For example, the voltage data may be a voltage acquired in a charging section, idle-after-charging section, discharging section, and/or idle-after-discharging section of each of the plurality of battery cells 110, 120, 130, and 140.

The controller 220 may calculate a voltage profile P representing a change in voltage of each of the plurality of battery cells 110, 120, 130, and 140 based on the voltage of each of the plurality of battery cells 110, 120, 130, and 140 per unit time. Here, the voltage profile P of each of the plurality of battery cells 110, 120, 130, and 140 may be a graph representing the OCV of the battery cell for time. For example, an x-axis of the voltage profile may be a time (unit: seconds) and a y-axis may be a voltage (unit: volts).

According to an embodiment, the controller 220 may calculate the voltage profile P of each of the plurality of battery cells 110, 120, 130, and 140 in the idle-after-charging-and-discharging sections. For example, the controller 220 may calculate the voltage profile P of each of the plurality of battery cells 110, 120, 130, and 140 in the idle section after the discharging of the plurality of battery cells 110, 120, 130, and 140 are completed.

According to an embodiment, the controller 220 may calculate the voltage profile of each of the plurality of battery cells 110, 120, 130, and 140 for the idle-after-discharging cycle of each of the plurality of battery cells 110, 120, 130, and 140.

Although FIG. 3 shows only the voltage profile P of the battery cell 110 in the idle section after discharging is completed, the controller 220 may calculate the voltage profile P of each of the other battery cells 120, 130, and 140. In addition, for the convenience of description, although the operation of the controller 220 is described below using the battery cell 110 as an example, the present document is not limited thereto, and the operation of the controller 220 may be applied to the other battery cells 120, 130, and 140 in the same manner.

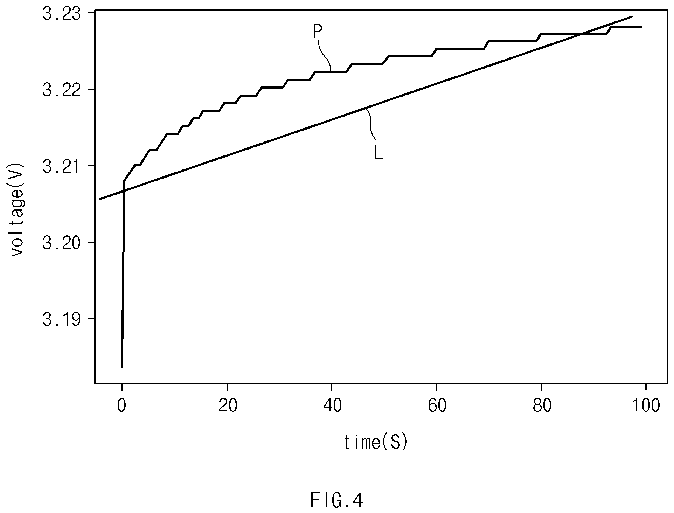

FIG. 4 is an enlarged view of the voltage profile of the battery cell according to one embodiment disclosed herein.

Referring to FIG. 4, the controller 220 may calculate the slope of the voltage profile P of the battery cell 110. According to an embodiment, the controller 220 may calculate a slope of the voltage profile P by linearly fitting the voltage profile P in a preset time section. Here, the preset time section may include the idle section after discharging is completed.

According to an embodiment, the controller 220 may determine that a predetermined time section immediately after discharging is completed is the preset time section. For example, the controller 220 may determine that the idle period from immediately after discharging is completed to 100 seconds is the preset time section. Therefore, the controller 220 may diagnose whether Li-plating has occurred through the changes in voltages of the plurality of battery cells 110, 120, 130, and 140 in the idle section after discharging is completed.

The slope of the voltage profile P of the battery cell 110 in the idle section after discharging is completed may have correlation with a speed at which lithium ions in the battery cell 110 return to an equilibrium state. For example, when the battery cell 110 is in a discharged state, lithium ions may move from the negative electrode to the positive electrode as a current is applied to the negative and positive electrodes of the battery cell 110. In addition, when the discharging is completed, lithium ions may return to the equilibrium state as a current is not applied to the battery cell 110. Here, lithium ions may move in a direction of eliminating a concentration gradient at the negative electrode and the positive electrode to return to the equilibrium state. Therefore, the voltage of the battery cell 110 may change in the idle-after-discharging section. However, when lithium plating occurs in the battery cell 110, the speed at which lithium ions return to the equilibrium state slows down, and thus the voltage of the battery cell 110 may change slowly.

Therefore, the controller 220 may calculate the slope, which is changes in voltage profiles of each of the plurality of battery cells 110, 120, 130, and 140 in the idle section after discharging is completed and diagnose the battery cell in which lithium plating has occurred. For example, when the slope of the voltage profile P of the battery cell 110 is smaller than the slopes of the voltage profiles of other battery cells (e.g., 120, 130, 140), the controller 220 may diagnose the battery cell 110 as a cell in which lithium plating has occurred.

According to an embodiment, the controller 220 may preprocess the voltage profile P of each of the plurality of battery cells 110, 120, 130, and 140 to calculate the slope of the voltage profile P. For example, the controller 220 may linearly fit the voltage profile P of each of the plurality of battery cells 110, 120, 130, and 140. Here, the linear fitting may mean linearly approximating data that is not linearly distributed.

According to an embodiment, the controller 220 may linearly fit the voltage profile P to a straight line. Therefore, the controller 220 may accurately calculate the slope of the voltage profile P in a distributed data format or a curved voltage profile P. In addition, the controller 220 may compare the slopes derived from the voltage profiles P of the plurality of battery cells 110, 120, 130, and 140 and diagnose the state of each of the plurality of battery cells 110, 120, 130, and 140.

According to an embodiment, the controller 220 may linearly fit the voltage profile P using any data fitting analysis method. For example, the controller 220 may linearly fit the voltage profile P using any regression analysis method. Here, the regression analysis method may include at least one of linear regression, polynomial regression, logarithmic regression, and exponential regression. According to an embodiment, the controller 220 may linearly fit the voltage profile P using a linear regression method of Python Scikit-Learn.

According to an embodiment, the controller 220 may calculate a linear profile L based on the voltage profile P. Here, the linear profile L may be a profile to which the voltage profile P is linearly fitted.

According to an embodiment, the controller 220 may calculate the slope of the voltage profile P based on the linear profile L. For example, the controller 220 may calculate the slope of the voltage profile P based on an average change rate of the linear profile L in the preset time section. In another aspect, the controller 220 may calculate, as the slope of the voltage profile P, a ratio of a voltage change amount of the linear profile L to a time change amount in the preset time section.

According to an embodiment, the controller 220 may diagnose each of the plurality of battery cells 110, 120, 130, and 140 based on the slope of the voltage profile P of each of the plurality of battery cells 110, 120, 130, and 140. According to an embodiment, the controller 220 may compare the slope of the voltage profile P of each of the plurality of battery cells 110, 120, 130, and 140 with a threshold value and diagnose a battery cell having a slope smaller than the threshold value as being in an abnormal state. Here, the threshold value may be a value that is a reference for diagnosing the battery cell as being in the abnormal state.

As described above, the slope of the voltage profile P may have correlation with the speed at which lithium ions return to the equilibrium state. Therefore, when Li-plating occurs in a specific battery cell (e.g., 110), the speed at which lithium ions return to the equilibrium state slows down, and thus the voltage of the battery cell 110 may change slowly. Therefore, the controller 220 may diagnose a battery cell in which the slope of the voltage profile P is smaller than the threshold value as the state in which Li-plating has occurred (i.e., the abnormal state).

According to an embodiment, the controller 220 may determine the threshold value based on the distribution of the slope of the voltage profile P of each of the plurality of battery cells 110, 120, 130, and 140. For example, the controller 220 may calculate the distribution of the slopes related to the plurality of battery cells 110, 120, 130, and 140. Here, the distribution of the slopes may be a probability distribution that has the slope of each of the plurality of battery cells 110, 120, 130, and 140 included in the battery cell pack 1000 as a probability variable.

Therefore, the controller 220 may calculate a probability distribution that has the slope of the voltage profile P of the plurality of battery cells 110, 120, 130, and 140 as the probability variable. According to an embodiment, the controller 220 may determine a threshold value based on the distribution of the slope of the voltage profile P. For example, the controller 220 may calculate an average and standard deviation of the distribution based on the distribution of the slope. Therefore, the controller 220 may determine that a reference value based on the average and standard deviation of the distribution is the threshold value. Therefore, the controller 220 may determine a battery cell in which the slope of the voltage profile P is an outlier among the plurality of battery cells 110, 120, 130, 140 included in the battery cell pack 1000.

According to an embodiment, when the distribution of the slopes of the voltage profiles P of the plurality of battery cells 110, 120, 130, and 140 is a normal distribution, the controller 220 may determine that any reliable section is a threshold value. For example, the controller 220 may determine that a section (e.g., 96%, 96.5%, 97%, 97.5%, ..., 99.5%) in which the reliable section is smaller than or equal than 95% is the threshold value.

According to an embodiment, the controller 220 may diagnose a battery cell having a slope of a voltage profile P smaller than the threshold value as a cell in which Li-plating has occurred. According to an embodiment, the controller 220 may diagnose an outlier battery cell better as the controller 220 determines a wider reliable section, that is, the controller 220 determines a smaller threshold value. Therefore, the controller 220 may diagnose a battery cell having a slope of a voltage profile P that is significantly smaller than other battery cells among the plurality of battery cells 110, 120, 130, and 140 as a battery cell in an abnormal state.

According to an embodiment, the controller 220 may determine a threshold value based on Equation 1 below.

<Equation 1>

$$x = m - (2.1 * \sigma)$$

In <Equation 1>, x denotes a threshold value, m denotes an average of the distribution of the slopes the voltage profiles P of the plurality of battery cells 110, 120, 130, and 140 included in the battery cell pack 1000, and $\sigma$ denotes a standard deviation of the distribution of the slopes of the voltage profiles P of the plurality of battery cells 110, 120, 130, and 140 included in the battery cell pack 1000.

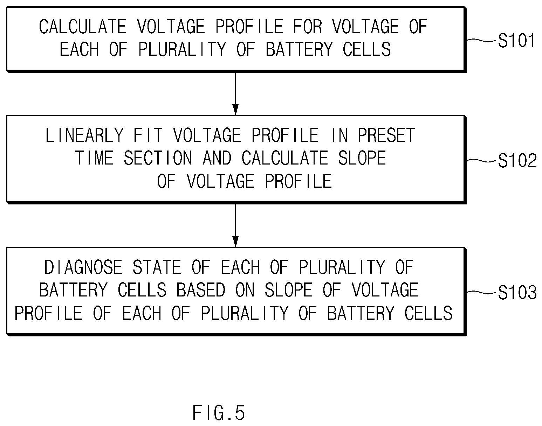

FIG. 5 is a flowchart of an operation of the battery management device according to one embodiment disclosed herein.

Referring to FIG. 5, an operation of the battery management device 200 may include calculating a voltage profile for a voltage of each of a plurality of battery cells (S101), linearly fitting the voltage profile in a preset time section and calculating a slope of the voltage profile (S102), and diagnosing a state of each of the plurality of battery cells based on the slope of the voltage profile of each of the plurality of battery cells (S103).

In operation S101, the controller 220 of the battery management device 200 may calculate the voltage profile P for the voltage of each of the plurality of battery cells 110, 120, 130, and 140 (S101). According to an embodiment, the controller 220 may calculate the voltage profile P of the OCV of each of the plurality of battery cells 110, 120, 130, and 140 in the idle-after-discharging section.

In operation S102, the controller 220 may linearly fit the voltage profile P in the preset time section and calculating the slope of the voltage profile P (S102). According to an embodiment, the controller 220 may determine that an idle section immediately after discharging of each of the plurality of battery cells 110, 120, 130, and 140 is completed is the preset time section.

In operation S103, the controller 220 may diagnose the state of each of the plurality of battery cells 110, 120, 130, and 140 based on the slope of the voltage profile P of each of the plurality of battery cells 110, 120, 130, and 140 (S103). According to an embodiment, the controller 220 may diagnose the battery cell having the slope of the voltage profile P smaller than the threshold value as a cell in which Li-plating has occurred.

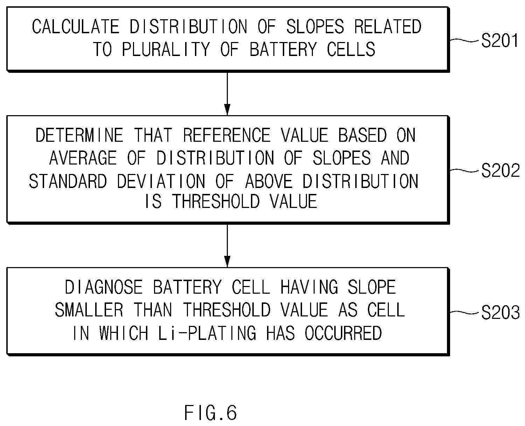

FIG. 6 is a flowchart of the operation of the battery management device according to one embodiment disclosed herein.

Referring to FIG. 6, an operation of the battery management device 200 may include calculating the distribution of slopes related to a plurality of battery cells (S201), determining that a reference value based on an average of the distribution of the slopes and a standard deviation of the distribution is a threshold value (S202), and diagnosing a battery cell having a slope smaller than the threshold value as a cell in which Li-plating has occurred (S203).

In operation S201, the controller 220 of the battery management device 200 may calculate the distribution of the slopes related to the plurality of battery cells 110, 120, 130, and 140 (S201). Here, the distribution of the slopes may be a probability distribution that has the slope of the voltage profile P of each of the plurality of battery cells 110, 120, 130, and 140 included in the battery cell pack 1000 as a probability variable.

In operation S202, the controller 220 may determine that the reference value based on the average of the distribution of the slopes and the standard deviation of the distribution is the threshold value (S202).

In operation S203, the controller 220 may diagnose the battery cell having the slope smaller than the threshold value as the cell in which Li-plating has occurred (S203).

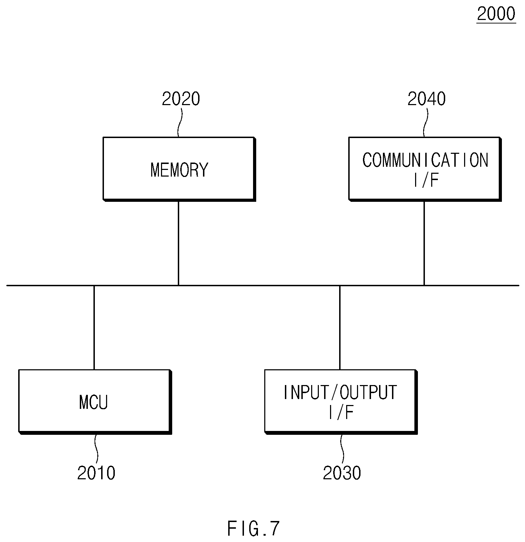

FIG. 7 is a block diagram showing a hardware configuration of a computing system for performing a method of operating the battery management device according to one embodiment disclosed herein.

Referring to FIG. 7, a computing system 2000 according to one embodiment disclosed in this document may include a micro controller unit (MCU) 2010, a memory 2020, an input/output I/F 2030, and a communication I/F 2040.

The MCU 2010 may be a processor configured to execute various programs (e.g., a battery cell data collection program, a profile calculation program, a data analysis program, a distribution calculation program, and a battery cell diagnosis program) stored in the memory 2020, process various pieces of information including battery cell data, data regression analysis data, probability distribution data, etc. through the programs, and perform functions of the controller 220 included in the battery management device 200 shown in FIGS. 1 to 6.

The memory 2020 may store various programs such as a battery cell data collection program, a profile calculation program, a data analysis program, a distribution calculation program, and a battery cell diagnosis program. In addition, the memory 2020 may store various pieces of information including battery cell data, data regression analysis data, probability distribution data, etc.

A plurality of memories 2020 may be provided as needed. The memory 2020 may be a volatile memory or a non-volatile memory. As the memory 2020 of the volatile memory, a RAM, a DRAM, a SRAM, or the like can be used. As the memory 2020 of the non-volatile memory, a ROM, a PROM, an EAROM, an EPROM, an EEPROM, a flash memory, or the like can be used. Examples of the above-listed memories 2020 are merely illustrative and are not limited to these examples.

The input/output I/F 2030 may be an interface for connecting an input device (not shown), such as a keyboard, a mouse, or a touch panel, and an output device, such as a display (not shown) with the MCU 2010 and allowing the input and output devices and the MCU 4610 to transmit and receive data.

The communication I/F 2040 is a component capable of transmitting and receiving various data to and from the server and may be various devices capable of supporting wired or wireless communication. For example, the battery management device 200 may transmit and receive various pieces of information including SOC, OCV, parameters, etc. of the battery cell from a separately provided external server through the communication I/F 2040.

As described above, the computer program according to one embodiment disclosed herein may be implemented as a module for performing the functions shown in FIG. 2, for example, by being recorded in the memory 2020 and processed by the MCU 2010.

As described above, although all the components constituting the embodiments disclosed herein were described as being coupled or operated by being coupled, the embodiments disclosed herein are not necessarily limited to these embodiments. In other words, one or more of all the components may be operated by being selectively coupled without departing from the scope of the purpose of the embodiments disclosed herein.

In addition, the terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above-described disclosure schematically describes the features of several embodiments so that those skilled in the art may better understand the aspects of the present disclosure. Those skilled in the art will readily appreciate that the present disclosure may be used as a basis for designing or modifying other structures to perform the same purpose or achieve the same advantage of the embodiments introduced herein. Furthermore, those skilled in the art will recognize that such equivalent configurations do not depart from the scope of the present disclosure, and various changes, substitutions, and modifications can be made herein without departing from the scope of the present disclosure.

[DESCRIPTION OF REFERENCE NUMERALS]

100: battery cell module
110, 120, 130, 140: battery cells
200: battery management device
210: acquisition unit
220: controller
300: relay
1000: battery cell pack
2000: computing system
2010: MCU
2020: memory
2030: input/output I/F
2040: communication I/F

P: voltage profile
L: linear profile

## Claims

1. A battery management device comprising:

   an acquisition unit configured to acquire voltages of a plurality of battery cells; and
   a controller configured to:

   calculate a voltage profile for a voltage of each of the plurality of battery cells;
   linearly fit the voltage profile in a preset time section and calculate a slope of the voltage profile; and
   diagnose a state of each of the plurality of battery cells based on the slope of the voltage profile of each of the plurality of battery cells.

2. The battery management device of claim 1, wherein the preset time section includes an idle section after discharging of each of the plurality of battery cells is completed.

3. The battery management device of claim 1, wherein the controller linearly fits the voltage profile of each of the plurality of battery cells using a linear regression method.

4. The battery management device of claim 1, wherein the controller is configured to:

   calculate a linear profile that is a profile obtained by linearly fitting the voltage profile; and
   calculate an average change rate that is a ratio of a voltage change amount to a time change amount in the linear profile and calculate the slope.

5. The battery management device of claim 1, wherein the controller compares the slope of each of the plurality of battery cells with a threshold value and diagnoses a battery cell having the slope smaller than the threshold value as being in an abnormal state.

6. The battery management device of claim 5, wherein the controller is configured to:

   calculate distribution of the slopes related to the plurality of battery cells; and
   determine the threshold value based on the distribution of the slopes.

7. The battery management device of claim 6, wherein the controller determines that a reference value based on an average of the distribution of the slopes and a standard deviation of the distribution is the threshold value.

8. The battery management device of claim 5, wherein the controller diagnoses the battery cell having the slope smaller than the threshold value as a cell in which Li-plating has occurred.

9. The battery management device of claim 1, wherein the voltage of each of the plurality of battery cells is an open circuit voltage (OCV).

10. A battery management method comprising:

    calculating a voltage profile for a voltage of each of a plurality of battery cells;
    linearly fitting the voltage profile in a preset time section and calculating a slope of the voltage profile; and
    diagnosing a state of each of the plurality of battery cells based on the slope of the voltage profile of each of the plurality of battery cells.

11. The battery management method of claim 10, wherein the preset time section includes an idle section after discharging of each of the plurality of battery cells is completed.

12. The battery management method of claim 10, comprising linearly fitting the voltage profile of each of the plurality of battery cells using a linear regression method.

13. The battery management method of claim 10, wherein the calculating of the slope of the voltage profile includes:

    calculating a linear profile that is a profile obtained by linearly fitting the voltage profile; and
    calculating an average change rate that is a ratio of a voltage change amount to a time change amount in the linear profile and calculating the slope.

14. The battery management method of claim 10, wherein the diagnosing of the state of each of the plurality of battery cells includes comparing the slope of each of the plurality of battery cells with a threshold value and diagnosing a battery cell having the slope smaller than the threshold value as being in an abnormal state.

15. The battery management method of claim 14, further comprising:

    calculating distribution of the slopes related to the plurality of battery cells; and
determining the threshold value based on the distribution of the slopes.

16. The battery management method of claim 15, wherein the determining of the threshold value based on the distribution of the slopes includes determining that a reference value based on an average of the distribution of the slopes and a standard deviation of the distribution is the threshold value.

17. The battery management method of claim 14, wherein the diagnosing of the battery cell having the slope smaller than the threshold value as being in the abnormal state is diagnosing the battery cell having the slope smaller than the threshold value as a cell in which Li-plating has occurred.

18. The battery management method of claim 10, wherein the voltage of each of the plurality of battery cells is an open circuit voltage (OCV).

1000

300

100

110

120

130

.
.
.

140

BATTERY
MANAGEMENT DEVICE
200

FIG.1

200

```
┌─────────────────────┐              ┌─────────────────────┐
│    ACQUISITION      │              │                     │
│       UNIT          │──────────────│    CONTROLLER       │
│       210           │              │       220           │
│                     │              │                     │
└─────────────────────┘              └─────────────────────┘
```

FIG.2

FIG.3

FIG.4

CALCULATE VOLTAGE PROFILE FOR VOLTAGE OF
EACH OF PLURALITY OF BATTERY CELLS ~S101

LINEARLY FIT VOLTAGE PROFILE IN PRESET
TIME SECTION AND CALCULATE SLOPE
OF VOLTAGE PROFILE ~S102

DIAGNOSE STATE OF EACH OF PLURALITY OF
BATTERY CELLS BASED ON SLOPE OF VOLTAGE
PROFILE OF EACH OF PLURALITY OF BATTERY CELLS ~S103

FIG.5

CALCULATE DISTRIBUTION OF SLOPES RELATED
TO PLURALITY OF BATTERY CELLS ~S201

DETERMINE THAT REFERENCE VALUE BASED ON
AVERAGE OF DISTRIBUTION OF SLOPES AND
STANDARD DEVIATION OF ABOVE DISTRIBUTION
IS THRESHOLD VALUE ~S202

DIAGNOSE BATTERY CELL HAVING SLOPE
SMALLER THAN THRESHOLD VALUE AS CELL
IN WHICH Li-PLATING HAS OCCURRED ~S203

FIG.6

2000

2020

MEMORY

2040

COMMUNICATION
I/F

MCU

INPUT/OUTPUT
I/F

2010

2030

FIG.7

## INTERNATIONAL SEARCH REPORT

| | International application No. |
|---|---|
| | **PCT/KR2024/012150** |

| | |
|---|---|
| **A.** | **CLASSIFICATION OF SUBJECT MATTER** |

**G01R 31/392**(2019.01)i; **G01R 31/382**(2019.01)i; **G01R 31/3835**(2019.01)i; **G01R 31/396**(2019.01)i; **G01R 31/36**(2006.01)i; **G01R 31/367**(2019.01)i; **G01R 19/12**(2006.01)i; **G06F 17/18**(2006.01)i; **B60L 58/16**(2019.01)i; **H01M 10/0525**(2010.01)i

According to International Patent Classification (IPC) or to both national classification and IPC

| | |
|---|---|
| **B.** | **FIELDS SEARCHED** |

Minimum documentation searched (classification system followed by classification symbols)

G01R 31/392(2019.01); G01R 19/00(2006.01); G01R 31/36(2006.01); G01R 31/367(2019.01); G01R 31/382(2019.01); G01R 31/50(2020.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 진단(diagnosis), 기울기(gradient), 전압(voltage), 리니어 피팅(Linear Fitting)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| Y | KR 10-2022-0019637 A (LG ENERGY SOLUTION, LTD.) 17 February 2022 (2022-02-17)<br>See paragraphs [0041]-[0069], claims 1-2 and figures 2-5. | 1-18 |
| Y | KR 10-2023-0023395 A (LG ENERGY SOLUTION, LTD.) 17 February 2023 (2023-02-17)<br>See paragraphs [0029]-[0034] and figures 1-2. | 1-18 |
| A | KR 10-2019-0012718 A (LG CHEM, LTD.) 11 February 2019 (2019-02-11)<br>See paragraph [0059], claim 12 and figure 4. | 1-18 |
| A | KR 10-2020-0101754 A (SAMSUNG SDI CO., LTD.) 28 August 2020 (2020-08-28)<br>See paragraphs [0055]-[0092] and figures 3-5. | 1-18 |
| A | JP 2021-135114 A (DENSO CORP.) 13 September 2021 (2021-09-13)<br>See paragraphs [0024]-[0028] and claims 1-2. | 1-18 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 November 2024** | **13 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/012150**

| Patent document cited in search report | | | Publication date (day/month/year) | Patent family member(s) | | | Publication date (day/month/year) |
|---|---|---|---|---|---|---|---|
| KR | 10-2022-0019637 | A | 17 February 2022 | CN | 115867815 | A | 28 March 2023 |
| | | | | EP | 4155744 | A1 | 29 March 2023 |
| | | | | EP | 4155744 | A4 | 29 November 2023 |
| | | | | JP | 2023-529734 | A | 11 July 2023 |
| | | | | JP | 7546702 | B2 | 06 September 2024 |
| | | | | US | 2023-0258725 | A1 | 17 August 2023 |
| | | | | WO | 2022-035149 | A1 | 17 February 2022 |
| KR | 10-2023-0023395 | A | 17 February 2023 | CN | 116569054 | A | 08 August 2023 |
| | | | | EP | 4276484 | A1 | 15 November 2023 |
| | | | | EP | 4276484 | A4 | 24 July 2024 |
| | | | | JP | 2024-506356 | A | 13 February 2024 |
| | | | | US | 2024-0142535 | A1 | 02 May 2024 |
| | | | | WO | 2023-018165 | A1 | 16 February 2023 |
| KR | 10-2019-0012718 | A | 11 February 2019 | KR | 10-2323035 | B1 | 05 November 2021 |
| KR | 10-2020-0101754 | A | 28 August 2020 | US | 11456610 | B2 | 27 September 2022 |
| | | | | US | 2020-0266645 | A1 | 20 August 2020 |
| JP | 2021-135114 | A | 13 September 2021 | JP | 7415654 | B2 | 17 January 2024 |

Form PCT/ISA/210 (patent family annex) (July 2022)

**EP 4 760 308 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230136073